# EUROPEAN PATENT APPLICATION

(11) **EP 4 482 028 A1**
(43) Date of publication of application: **25.12.2024**
(21) Application number: 24181298.1
(22) Date of filing: 11.06.2024
(51) Int. Cl.: H03F 1/02, H03F 3/195, H03F 3/24, H03G 3/30

(54) **ELECTRONIC DEVICE**

(30) Priority: 19.06.2023 TW 112122889
(71) Applicant: Hexawave, Inc., Hsinchu 300091 (TW)
(72) Inventor: WU, Chih-Wen, 300091 Hsinchu (TW)
(74) Representative: Patentship Patentanwaltsgesellschaft mbH

(57) **Abstract**

An electronic device (100) includes a driving amplifier (108), a power amplifier (102), a power detector (104), and a bias circuit (106). The driving amplifier (108) outputs a radio frequency (RF) signal (132). The power amplifier (102) is electrically connected to the driving amplifier (108). The power amplifier (102) includes an input end. The power amplifier (102) receives the RF signal (132) through the input end. The power amplifier (102) amplifies the RF signal (132). The power detector (104) is electrically coupled to the input end and detects the input power of the RF signal (132). The power detector (104) outputs a driving voltage (120) according to the input power. The bias circuit (106) is electrically connected to the power amplifier (102) and the power detector (104). The bias circuit (106) outputs a first driving current (122) to the power amplifier (102) according to the driving voltage (120). The power amplifier (102) amplifies the power of the RF signal (132) from the input power to a target power according to the first driving current (122).

## Description

### TECHNICAL FIELD

The present application relates to an electronic device, and, in particular, to a power amplifier with adaptive bias adjustment function.

### DESCRIPTION OF BACKGRIUND ART

RF power amplifiers are often used in wireless communication products to amplify RF signals so that the RF signals can be radiated through the antenna to the receiving device. However, in the existing technology, the configuration and design of the bias circuit of the power amplifier often determine the gain and efficiency of the power amplifier. In order to save the power consumption of the power amplifier, how to increase the power added efficiency (PAE) of the power amplifier has become an important issue.

### BRIEF SUMMARY OF THE APPLICATION

An embodiment of the present application provides an electronic device. The electronic device includes a driving amplifier, a power amplifier, a power detector, and a bias circuit. The driving amplifier outputs a radio frequency (RF) signal. The power amplifier is electrically connected to the driving amplifier. The driving amplifier includes an input end. The driving amplifier receives the RF signal through the input end. The driving amplifier amplifies the RF signal. The power detector is electrically coupled to the input end. The power detector detects the input power of the RF signal and outputs a driving voltage according to the input power. The bias circuit is electrically connected to the power amplifier and the power detector. The bias circuit outputs a first driving current to the power amplifier according to the driving voltage. The power amplifier amplifies the power of the RF signal from the input power to a target power according to the first driving current.

More specifically, the invention relates to an electronic device which comprises: a driving amplifier, configured to output a radio frequency (RF) signal; a power amplifier, electrically connected to the driving amplifier, comprising an input end, configured to receive the RF signal through the input end, and amplify the RF signal; a power detector, electrically coupled to the input end, configured to detect an input power of the RF signal, and output a driving voltage according to the input power; and a bias circuit, electrically connected to the power amplifier and the power detector, configured to output a first driving current to the power amplifier according to the driving voltage; wherein the power amplifier amplifies the power of the RF signal from the input power to a target power according to the first driving current.

In a first embodiment of the invention, the bias circuit comprises: a first transistor, having a first end electrically coupled to a first voltage, a second end electrically coupled to the power amplifier, and a third end electrically connected to a ground voltage; a second transistor, having a first end electrically connected to the first voltage, and a second end electrically coupled to the first end of the first transistor; and a third transistor, having a first end electrically connected to the third end of the second transistor, a second end electrically connected to the power detector, and a third end electrically connected to the power amplifier.

In a second embodiment of the invention in combination with the first embodiment of the invention, the bias circuit comprises: a first resistor, electrically connected between the second end of the first transistor and the power amplifier; a second resistor, electrically connected between the second end of the second transistor and the first end of the first transistor; a third resistor, electrically connected between the first end of the first transistor and the first voltage; and a fourth resistor, electrically connected between the third end of the third transistor and the ground voltage.

In a third embodiment of the invention in combination with the second embodiment of the invention, the power amplifier comprises a fourth transistor, having a first end electrically coupled to a second voltage, a second end electrically connected to the third end of the third transistor and the first resistor, and a third end electrically connected to the fourth resistor and the ground voltage.

In a fourth embodiment of the invention in combination with the third embodiment of the invention, the electronic device further comprises a first capacitor, electrically connected between the input end and the third end of the third transistor.

In a fifth embodiment of the invention in combination with the third embodiment of the invention, the power amplifier comprises: a second capacitor, electrically connected between an output end and the first end of the fourth transistor; and a first inductor, electrically connected between the second voltage and the first end of the fourth transistor.

In a sixth embodiment of the invention, the electronic device further comprises a coupling element, electrically connected between the input end and the power detector, configured to couple the RF signal to the power detector.

In a seventh embodiment of the invention, the electronic device further comprises a second bias circuit, electrically connected to the driving amplifier, configured to output a second driving current to the driving amplifier; wherein the second driving current is less than the first driving current.

In an eighth embodiment of the invention in combination with the third embodiment of the invention, the third transistor outputs the first driving current to the fourth transistor according to the driving voltage from the power detector.

In a ninth embodiment of the invention in combination with the third embodiment of the invention, the fourth resistor is configured to adjust a turn-on voltage of the fourth transistor.

In a tenth embodiment of the invention in combination with the third embodiment of the invention, the first transistor, the second transistor, the fourth transistor, the first resistor, the second resistor, and the third resistor are combined into a current mirror.

In an eleventh embodiment of the invention in combination with the third embodiment of the invention, each of the first transistor, the second transistor, the third transistor, and the fourth transistor is a bipolar junction transistor (BJT).

In a twelfth embodiment of the invention in combination with the eleventh embodiment of the invention, each of the first transistor, the second transistor, the third transistor, and the fourth transistor is an NPN-type BJT.

In a thirteenth embodiment of the invention in combination with the third embodiment of the invention, the first voltage and the second voltage are the same or different.

In a fourteenth embodiment of the invention, the driving amplifier amplifies the power of the RF signal from an initial power to the input power.

### BRIEF DESCRIPTION OF THE DRAWINGS

The present application can be more fully understood by reading the subsequent detailed description and examples with references made to the accompanying drawings, wherein:
FIG. 1 is a schematic diagram of an electronic device 100 in accordance with some embodiments of the present application.
FIG. 2 is a detail circuit diagram of a power amplifier 102 and a bias circuit 106 in the electronic device 100 in accordance with some embodiments of the present application.
FIG. 3 is a detail circuit diagram of a power amplifier 102 and a bias circuit 106 in an electronic device 300 in accordance with some embodiments of the present application.
FIG. 4 is a detail circuit diagram of a power amplifier 102 and a bias circuit 106 in an electronic device 400 in accordance with some embodiments of the present application.
FIG. 5A is a graph of power added efficiency (PAE) versus output power of a power amplifier in the prior art.
FIG. 5B is a graph of power added efficiency (PAE) versus output power of the power amplifier 102 in the electronic device 100 in accordance with some embodiments of the present application.

### DETAILED DESCRIPTION OF THE APPLICATION

In order to make the above purposes, features, and advantages of some embodiments of the present application more comprehensible, the following is a detailed description in conjunction with the accompanying drawing.

Certain terms are used throughout the description and following claims to refer to particular components. As one skilled in the art will understand, electronic equipment manufacturers may refer to a component by different names. This document does not intend to distinguish between components that differ in name but not function. It is understood that the words "comprise", "have" and "include" are used in an openended fashion, and thus should be interpreted to mean "include, but not limited to...". Thus, when the terms "comprise", "have" and/or "include" used in the present application are used to indicate the existence of specific technical features, values, method steps, operations, units and/or components. However, it does not exclude the possibility that more technical features, numerical values, method steps, work processes, units, components, or any combination of the above can be added.

The directional terms used throughout the description and following claims, such as: "on", "up", "above", "down", "below", "front", "rear", "back", "left", "right", etc., are only directions referring to the drawings. Therefore, the directional terms are used for explaining and not used for limiting the present application. Regarding the drawings, the drawings show the general characteristics of methods, structures, and/or materials used in specific embodiments. However, the drawings should not be construed as defining or limiting the scope or properties encompassed by these embodiments. For example, for clarity, the relative size, thickness, and position of each layer, each area, and/or each structure may be reduced or enlarged.

When the corresponding component such as layer or area is referred to as being "on another component", it may be directly on this other component, or other components may exist between them. On the other hand, when the component is referred to as being "directly on another component (or the variant thereof)", there is no component between them. Furthermore, when the corresponding component is referred to as being "on another component", the corresponding component and the other component have a disposition relationship along a top-view/vertical direction, the corresponding component may be below or above the other component, and the disposition relationship along the top-view/vertical direction is determined by the orientation of the device.

It should be understood that when a component or layer is referred to as being "connected to" another component or layer, it can be directly connected to this other component or layer, or intervening components or layers may be present. In contrast, when a component is referred to as being "directly connected to" another component or layer, there are no intervening components or layers present.

The electrical connection or coupling described in this disclosure may refer to direct connection or indirect connection. In the case of direct connection, the endpoints of the components on the two circuits are directly connected or connected to each other by a conductor line segment, while in the case of indirect connection, there are switches, diodes, capacitors, inductors, resistors, other suitable components, or a combination of the above components between the endpoints of the components on the two circuits, but the intermediate component is not limited thereto.

The words "first", "second", "third", "fourth", "fifth", and "sixth" are used to describe components. They are not used to indicate the priority order of or advance relationship, but only to distinguish components with the same name.

It should be noted that the technical features in different embodiments described in the following can be replaced, recombined, or mixed with one another to constitute another embodiment.

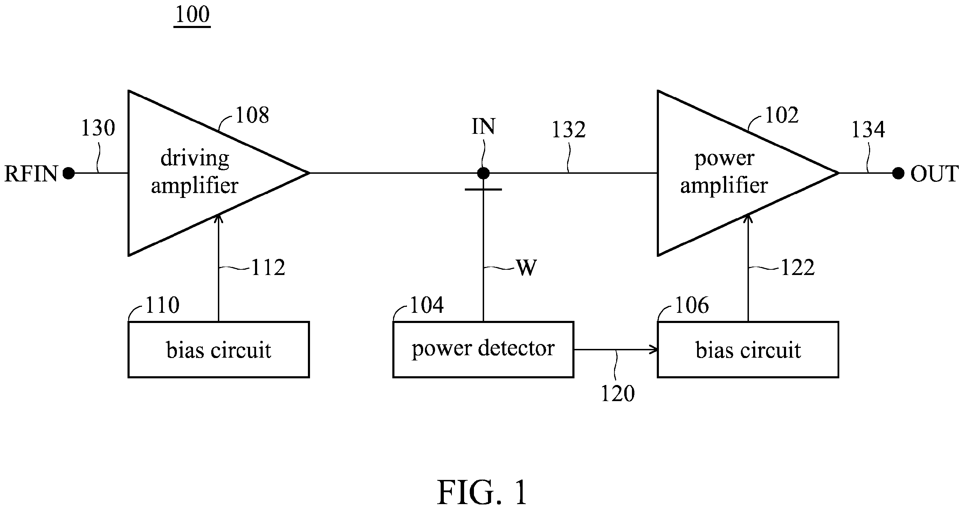

FIG. 1 is a schematic diagram of an electronic device 100 in accordance with some embodiments of the present application. As shown in FIG. 1, the electronic device 100 includes a power amplifier 102, a power detector 104, a bias circuit 106, a driving amplifier 108, and a bias circuit 110. In some embodiments, the electronic device 100 is designed based on the architecture of Doherty power amplifier made by the heterojunction bipolar transistor (HBT) process, but the present application is not limited thereto. In some embodiments, the power amplifier 102 includes an input end IN. The power amplifier 102 receives a radio frequency (RF) signal 132 through the input end IN, and amplifies the RF signal 132. The power of the RF signal 132 is the same as the input power W. The power detector 104 is electrically coupled to the input end IN. The power detector 104 detects the input power W of the RF signal 132 and outputs a driving voltage 120 to the bias circuit 106 according to the input power W. For example, when the input power W of the RF signal 132 is higher, the driving voltage 120 output by the power detector 104 is higher, but the present application is not limited thereto. In some embodiments, the driving voltage 120 is a DC voltage, but the present application is not limited thereto.

In some embodiments, the bias circuit 106 is electrically connected to the power amplifier 102 and the power detector 104. The bias circuit 106 outputs a driving current 122 to the power amplifier 102 according to the driving voltage 120. In some embodiments, the driving current 122 is a DC current, but the present invention is not limited thereto. The power amplifier 102 amplifies the power of the RF signal 132 from the input power W to a target power according to the driving current 122 to generate an RF signal 134. The power amplifier 102 outputs the amplified RF signal 134 through an output end OUT. In some embodiments, the amplified RF signal 134 may be radiated to a receiving device through an antenna (not shown). In some embodiments, the driving amplifier 108 is electrically connected to the input end IN of the power amplifier 102. The driving amplifier 108 amplifies the RF signal 130 with the initial power to the RF signal 132 with the input power W. The driving amplifier 108 receives the RF signal 130 through an input end RFIN.

In some embodiments, the RF signal 130 may come from a radio frequency transceiver (not shown). The radio frequency transceiver can, for example, convert a digital signal into a base band signal, convert the base band signal into an intermediate frequency signal, and then convert the intermediate frequency signal into a radio frequency signal, but the present invention is not limited thereto. In some embodiments of FIG. 1, the bias circuit 106 used to drive the power amplifier 102 is different from the bias circuit 110 used to drive the driving amplifier 108, but the present invention is not limited thereto. The driving amplifier 108 is used to amplify the RF signal 130 in the first stage. The power amplifier 102 is used to amplify the RF signal 130 in the second stage. In some embodiments, the power amplifier 102 is the last stage amplifier before the antenna, but the present application is not limited thereto. In some embodiments, the power detector 104 can detect the input power W of the RF signal 132 in any form. For example, the power detector 104 can detect the voltage and current of the coupled signal from the RF signal 132 coupled to the power detector 104, and calculate the power of the coupled signal based on the voltage and current of the coupled signal. The power detector 104 finally converts the power of the coupled signal into the input power W of the RF signal 132, but the present application is not limited thereto. In some embodiments, the bias circuit 110 is electrically connected to the driving amplifier 108 to output a driving current 112 to the driving amplifier 108. In some embodiments, the driving current 112 is less than the driving current 122, but the present application is not limited thereto. The driving current 112 is the same as the driving current 122 and is also a DC current, but the present application is not limited thereto.

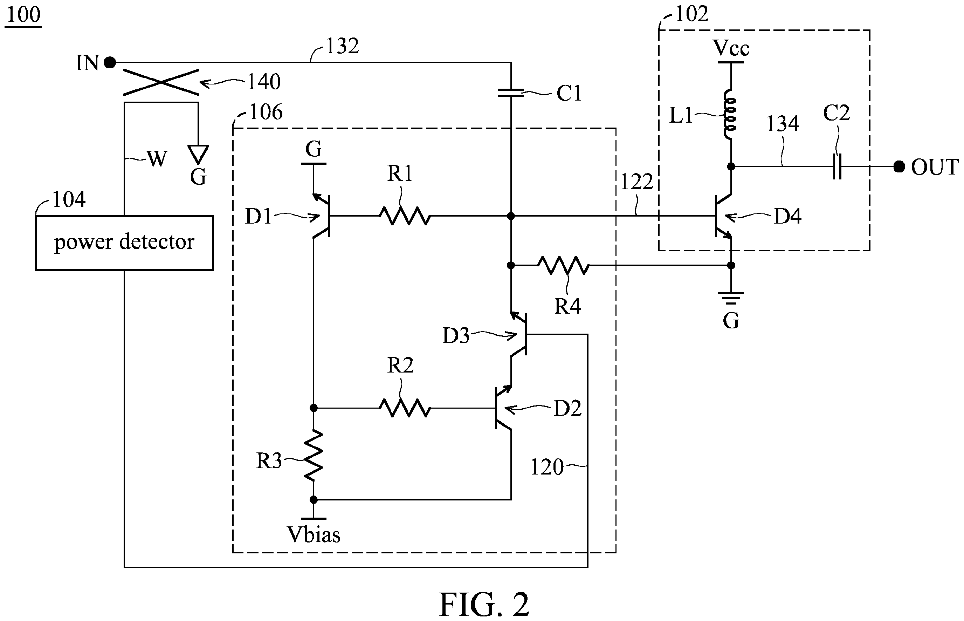

FIG. 2 is a detail circuit diagram of a power amplifier 102 and a bias circuit 106 in the electronic device 100 in accordance with some embodiments of the present application. As shown in FIG. 2, the bias circuit 106 includes a first transistor D1, a second transistor D2, a third transistor D3, a first resistor R1, a second resistor R2, a third resistor R3, and a fourth resistor R4. The power amplifier 102 includes a fourth transistor D4, a capacitor C2, and an inductor L1. In some embodiments of FIG. 2, the first end of the first transistor D1 is electrically coupled to a first voltage Vbias through the third resistor R3. The second end of the first transistor D1 is electrically coupled to the second end of the fourth transistor D4 in the power amplifier 102 through the first resistor R1. The third end of the first transistor D1 is electrically connected to a ground voltage G. The first end of the second transistor D2 is electrically connected to the first voltage Vbias. The second end of the second transistor D2 is electrically coupled to the first end of the first transistor D1 through the second resistor R2. The first end of the third transistor D3 is electrically connected to the third end of the second transistor D2. The second end of the third transistor D3 is electrically connected to the power detector 104. The third end of the third transistor D3 is electrically connected to the second end of the fourth transistor D4 in the power amplifier 102.

In detail, the first resistor R1 is electrically connected between the second end of the first transistor D1 and the second end of the fourth transistor D4 in the power amplifier 102. The second resistor R2 is electrically connected between the second end of the second transistor D2 and the first end of the first transistor D1. The third resistor R3 is electrically connected between the first end of the first transistor D1 and the first voltage Vbias. The fourth resistor R4 is electrically connected between the third end of the third transistor D3 and the ground voltage G. In some embodiments of FIG. 2, the electronic device 100 further includes a coupling element 140. The coupling element 140 is electrically connected between the input end IN and the power detector 104 to couple the RF signal 132 to the power detector 104. In some embodiments, the coupling element 140 is electrically coupled to the ground voltage G, but the present application is not limited thereto. The power detector 104 is electrically connected to the second end of the third transistor D3 in the bias circuit 106. In some embodiments, each of the first transistor D1, the second transistor D2, the third transistor D3, and the fourth transistor D4 is a bipolar junction transistor (BJT), but the present application is not limited thereto. In some embodiments, each of the first transistor D1, the second transistor D2, the third transistor D3, and the fourth transistor D4 is an NPN-type BJT, but the present application is not limited thereto.

In some embodiments, the power detector 104 detects the input power W of the RF signal 132 and outputs the driving voltage 120 to the second end of the third transistor D3 in the bias circuit 106 according to the input power W. For example, when the input power W of the RF signal 132 is higher, the driving voltage 120 output by the power detector 104 is higher, but the present application is not limited thereto. The third transistor D3 outputs a driving current 122 from its third end to the second end of the fourth transistor D4 in the power amplifier 102 according to the driving voltage 120. For example, when the driving voltage 120 from the power detector 104 is higher, the driving current 122 output from the third end of the third transistor D3 to the second end of the fourth transistor D4 is larger. In some embodiments, the fourth resistor R4 can adjust the turn-on voltage of the fourth transistor D4. For example, it is assumed that the forward bias voltage from the second end to the third end of the third transistor D3 is 0.7V, and the forward bias voltage from the second end to the third end of the fourth transistor D4 is 0.7V. When the fourth resistor R4 is not provided, the driving voltage 120 may need to be higher than 1.4V to cause the third transistor D3 to start outputting the driving current 122. In contrast, in the bias circuit 106 of the present application, since the fourth resistor R4 is electrically connected between the ground voltage G and the third end of the third transistor D3, the driving voltage 120 only needs to be higher than 0.7V for the third transistor D3 to start outputting the driving current 122.

In some embodiments of FIG. 2, the first transistor D 1, the second transistor D2, the first resistor R1, the second resistor R2, and the third resistor R3 in the bias circuit 106 and the fourth transistor D4 in the power amplifier 104 are combined into a current mirror, but the present application is not limited thereto. The fourth transistor D4 amplifies the power of the RF signal 132 from the input power W to a target power according to the driving current 122. In some embodiments, the fourth transistor D4 is simultaneously driven by the driving current 122 from the third transistor D3 and the current from the second voltage Vcc. In detail, the first end of the fourth transistor D4 is electrically coupled to the second voltage Vcc through the inductor L1. The second end of the fourth transistor D4 is electrically connected to the third end of the third transistor D3 and the first resistor R1. The third end of the fourth transistor D4 is electrically connected to the fourth resistor R4 and the ground voltage G. The capacitor C2 is electrically connected between the output end OUT and the first end of the fourth transistor D4. The inductor L1 is electrically connected between the second voltage Vcc and the first end of the fourth transistor D4. The fourth transistor D4 outputs the amplified RF signal 134 through the output end OUT.

In some embodiments, the first voltage Vbias may be the same as or different from the second voltage Vcc. In some embodiments, the electronic device 100 in FIG. 2 further includes a capacitor C1. The capacitor C1 is electrically connected between the input end IN and the third end of the third transistor D3. In some embodiments, the capacitor C1 is used to block the DC component from the first voltage Vbias to prevent the DC component of the first voltage Vbias from entering the input end IN. The capacitor C2 is used to block the DC component from the second voltage Vcc to prevent the DC component of the second voltage Vcc from entering the output end OUT. The inductor L1 is used to block the amplified RF signal 134 to prevent the RF signal 134 from interfering with the second voltage Vcc.

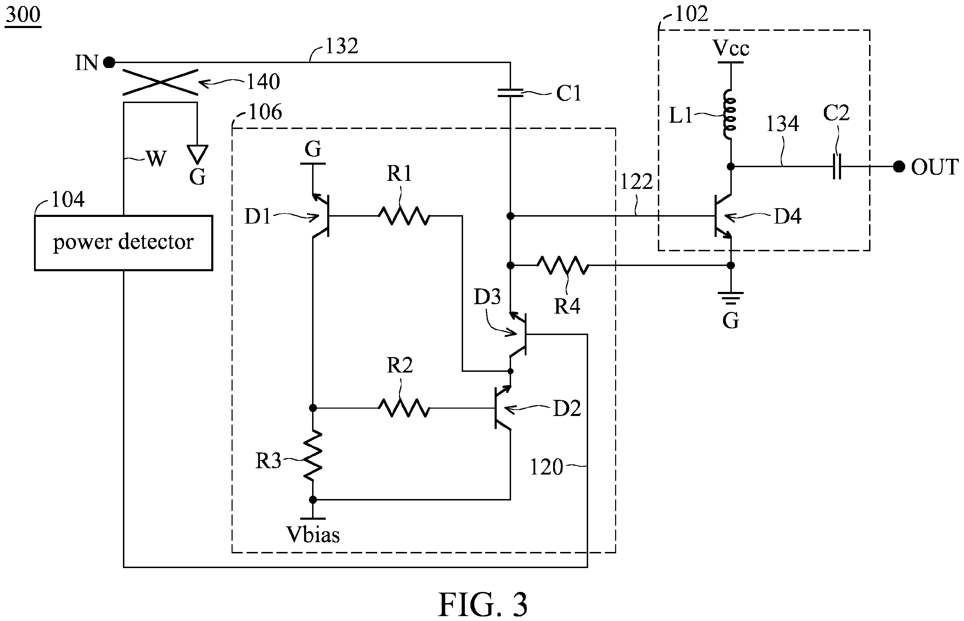

FIG. 3 is a detail circuit diagram of a power amplifier 102 and a bias circuit 106 in an electronic device 300 in accordance with some embodiments of the present application. As shown in FIG. 3, the bias circuit 106 includes a first transistor D1, a second transistor D2, a third transistor D3, a first resistor R1, a second resistor R2, a third resistor R3, and a fourth resistor R4. In some embodiments of FIG. 3, the first end of the first transistor D1 is electrically coupled to the first voltage Vbias through the third resistor R3. The second end of the first transistor D1 is electrically connected to the third end of the second transistor D2 and the first end of the third transistor D3 through the first resistor R1. The third end of the first transistor D1 is electrically connected to the ground voltage G. The first end of the second transistor D2 is electrically connected to the first voltage Vbias. The second end of the second transistor D2 is electrically coupled to the first end of the first transistor D1 through the second resistor R2. The first end of the third transistor D3 is electrically connected to the third end of the second transistor D2. The second end of the third transistor D3 is electrically connected to the power detector 104. The third end of the third transistor D3 is electrically connected to the second end of the fourth transistor D4 in the power amplifier 102.

In detail, the first resistor R1 is electrically connected between the second end of the first transistor D1 and the third end of the second transistor D2. On the other hand, the first resistor R1 is also electrically connected between the second end of the first transistor D1 and the first end of the third transistor D3. In the electronic device 300 in FIG. 3, except for the arrangement of the resistor R1 which is different from the electronic device 100 in FIG. 2, the arrangement of other components in the electronic device 300 is the same as that of the electronic device 100, and therefore will not be described again.

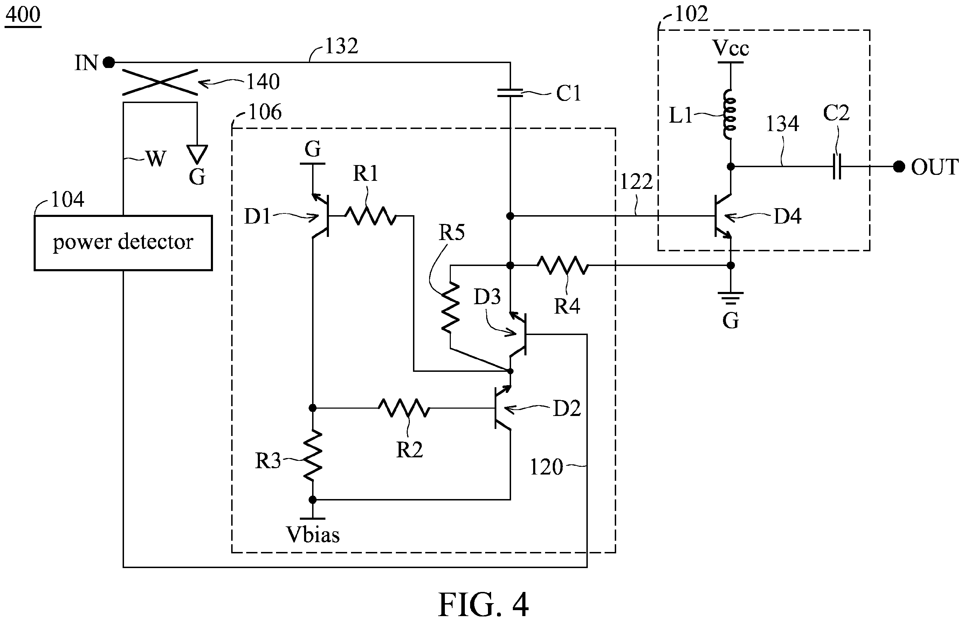

FIG. 4 is a detail circuit diagram of a power amplifier 102 and a bias circuit 106 in an electronic device 400 in accordance with some embodiments of the present application. As shown in FIG. 4, the bias circuit 106 includes a first transistor D1, a second transistor D2, a third transistor D3, a first resistor R1, a second resistor R2, a third resistor R3, a fourth resistor R4, and a fifth resistor R5. In some embodiments of FIG. 4, the first end of the first transistor D1 is electrically coupled to the first voltage Vbias through the third resistor R3. The second end of the first transistor D1 is electrically connected to the third end of the second transistor D2 and the first end of the third transistor D3 through the first resistor R1. The third end of the first transistor D1 is electrically connected to the ground voltage G. The first end of the second transistor D2 is electrically connected to the first voltage Vbias. The second end of the second transistor D2 is electrically coupled to the first end of the first transistor D1 through the second resistor R2. The first end of the third transistor D3 is electrically connected to the third end of the second transistor D2. The second end of the third transistor D3 is electrically connected to the power detector 104. The third end of the third transistor D3 is electrically connected to the second end of the fourth transistor D4 in the power amplifier 102. The fifth resistor R5 is connected across the first end of the third transistor D3 and the third end of the third transistor D3. In some embodiments, the fifth resistor R5 is used to prevent reverse bias voltage, but the present application is not limited thereto. In the electronic device 400 in FIG. 4, except for the arrangement of the resistor R5 which is different from the electronic device 300 in FIG. 3, the arrangement of other components in the electronic device 400 is the same as that of the electronic device 300, and therefore will not be described again..

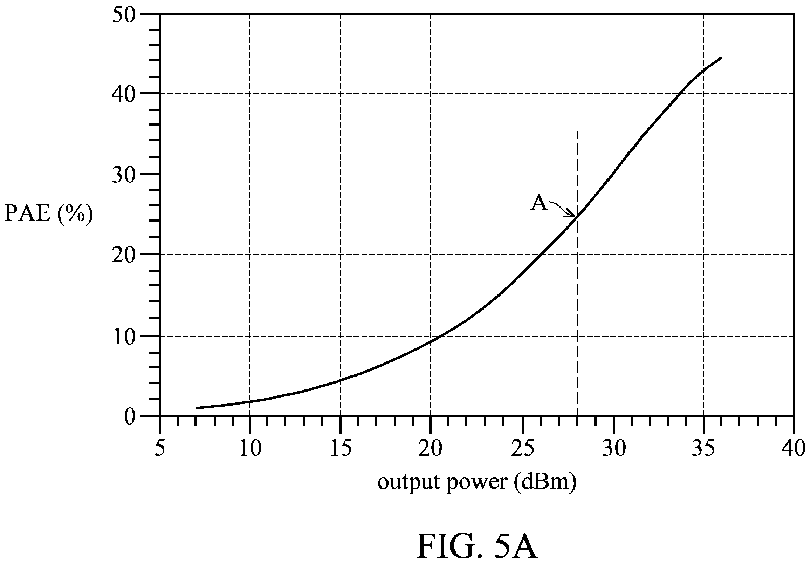

FIG. 5A is a graph of power added efficiency (PAE) versus output power of a power amplifier in the prior art. The horizontal axis of FIG. 5A is output power (dBm), and the vertical axis is PAE (%). The power amplifier in the prior art lacks the power detector 104 in the electronic device 100 of FIG. 1 of the present application, and its bias circuit is different from the bias circuit 106 of the present application. In some embodiments, the power added efficiency is equal to the ratio of the output power and the DC consumed power for the RF signal, that is, PAE = (Pout-Pin)/Pdc. PAE is the power added efficiency, Pout is the output power of the RF signal, Pin is the input power of the RF signal, and Pdc is the DC consumed power. As shown in FIG. 5A, referring to point A in FIG. 5A, when the output power of the power amplifier in the prior art is 28dBm, the PAE of the power amplifier in the prior art is 25%.

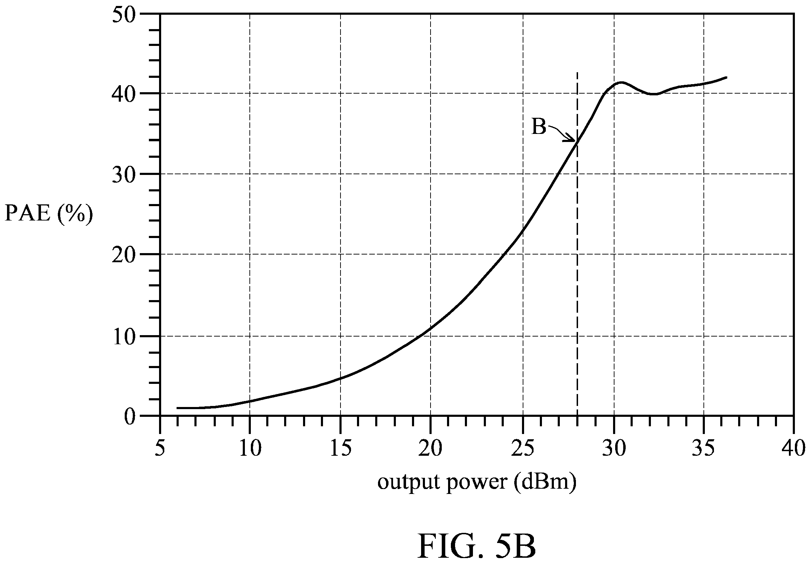

FIG. 5B is a graph of power added efficiency (PAE) versus output power of the power amplifier 102 in the electronic device 100 in accordance with some embodiments of the present application. The horizontal axis of FIG. 5B is output power (dBm), and the vertical axis is PAE (%). As shown in FIG. 5B, referring to point B in FIG. 5B, when the output power of the power amplifier 102 in the electronic device 100 is 28dBm, through the setting of the bias circuit 106, the PAE of the power amplifier 102 of the present application is increased to 35%. In other words, under the same output power as the RF signal, the power amplifier 102 in the electronic device 100 of the present application can increase the PAE by 10% over the power amplifier of the prior art, thereby achieving the purpose of effectively saving power.

While the application has been described by way of example and in terms of the preferred embodiments, it should be understood that the application is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An electronic device (100, 300, 400), comprising:
a driving amplifier (108), configured to output a radio frequency, RF, signal (132);
a power amplifier (102), electrically connected to the driving amplifier (108), comprising an input end, configured to receive the RF signal (132) through the input end, and amplify the RF signal (132);
a power detector (104), electrically coupled to the input end, configured to detect an input power of the RF signal (132), and output a driving voltage (120) according to the input power; and
a bias circuit (106), electrically connected to the power amplifier (102) and the power detector (104), configured to output a first driving current (122) to the power amplifier (102) according to the driving voltage (120);
wherein the power amplifier (102) amplifies the power of the RF signal (132) from the input power to a target power according to the first driving current (122).

2. The electronic device (100, 300, 400) as claimed in claim 1, wherein the bias circuit (106) comprises:
a first transistor (D 1), having a first end electrically coupled to a first voltage, a second end electrically coupled to the power amplifier (102), and a third end electrically connected to a ground voltage;
a second transistor (D2), having a first end electrically connected to the first voltage, and a second end electrically coupled to the first end of the first transistor (D1); and
a third transistor (D3), having a first end electrically connected to the third end of the second transistor (D2), a second end electrically connected to the power detector (104), and a third end electrically connected to the power amplifier (102).

3. The electronic device (100, 300, 400) as claimed in claim 2, wherein the bias circuit (106) comprises:
a first resistor (R1), electrically connected between the second end of the first transistor (D1) and the power amplifier (102);
a second resistor (R2), electrically connected between the second end of the second transistor (D2) and the first end of the first transistor (D1);
a third resistor (R3), electrically connected between the first end of the first transistor (D1) and the first voltage; and
a fourth resistor (R4), electrically connected between the third end of the third transistor (D3) and the ground voltage.

4. The electronic device (100, 300, 400) as claimed in claim 3, wherein the power amplifier (102) comprises:
a fourth transistor (D4), having a first end electrically coupled to a second voltage, a second end electrically connected to the third end of the third transistor (D3) and the first resistor (R1), and a third end electrically connected to the fourth resistor (R4) and the ground voltage.

5. The electronic device (100, 300, 400) as claimed in claim 4, further comprising:
a first capacitor (C1), electrically connected between the input end and the third end of the third transistor (D3).

6. The electronic device (100, 300, 400) as claimed in claim 4, wherein the power amplifier (102) comprises:
a second capacitor (C2), electrically connected between an output end and the first end of the fourth transistor (D4); and
a first inductor (L1), electrically connected between the second voltage and the first end of the fourth transistor (D4).

7. The electronic device (100, 300, 400) as claimed in claim 1, further comprising:
a coupling element (140), electrically connected between the input end and the power detector (104), configured to couple the RF signal (132) to the power detector (104).

8. The electronic device (100, 300, 400) as claimed in claim 1, further comprising
a second bias circuit, electrically connected to the driving amplifier (108), configured to output a second driving current to the driving amplifier (108);
wherein the second driving current is less than the first driving current (122).

9. The electronic device (100, 300, 400) as claimed in claim 4, wherein the third transistor (D3) outputs the first driving current (122) to the fourth transistor (D4) according to the driving voltage (120) from the power detector (104).

10. The electronic device (100, 300, 400) as claimed in claim 4, wherein the fourth resistor (R4) is configured to adjust a turn-on voltage of the fourth transistor (D4).

11. The electronic device (100, 300, 400) as claimed in claim 4, wherein the first transistor (D1), the second transistor (D2), the fourth transistor (D4), the first resistor (R1), the second resistor (R2), and the third resistor (R3) are combined into a current mirror.

12. The electronic device (100, 300, 400) as claimed in claim 4, wherein each of the first transistor (D1), the second transistor (D2), the third transistor (D3), and the fourth transistor (D4) is a bipolar junction transistor, BJT.

13. The electronic device (100, 300, 400) as claimed in claim 12, wherein each of the first transistor (D1), the second transistor (D2), the third transistor (D3), and the fourth transistor (D4) is an NPN-type BJT.

14. The electronic device (100, 300, 400) as claimed in claim 4, wherein the first voltage and the second voltage are the same or different.

15. The electronic device (100, 300, 400) as claimed in claim 1, wherein the driving amplifier (108) amplifies the power of the RF signal from an initial power to the input power.
